# EUROPEAN PATENT SPECIFICATION

(11) **EP 1 698 046 B1**
(45) Date of publication and mention of the grant of the patent: **19.03.2014**
(21) Application number: 03781241.9
(22) Date of filing: 19.12.2003
(51) Int. Cl.: H03B 19/14

(54) **FREQUENCY MULTIPLYING ARRANGEMENTS AND A METHOD FOR FREQUENCY MULTIPLICATION**
FREQUENZVERVIELFACHUNGSANORDNUNGEN UND VERFAHREN ZUR FREQUENZVERVIELFACHUNG
AGENCEMENTS DE MULTIPLICATION DE FREQUENCE ET METHODE POUR UNE MULTIPLICATION DE FREQUENCE

(43) Date of publication of application: 06.09.2006
(73) Proprietor: Telefonaktiebolaget LM Ericsson (publ), 164 83 Stockholm (SE)
(72) Inventor: ZIRATH, Herbert, S-431 36 Mölndal (SE)
(74) Representative: Althoff, Fredrik
(86) International application number: PCT/SE2003/002017
(87) International publication number: WO 2005/060088

(56) References cited:
- EP-A1- 0 487 386
- DE-A1- 10 219 374
- DE-A1- 10 232 861
- DE-C1- 3 524 112
- JP-A- 60 062 707
- JP-A- 600 054 503
- US-A- 4 130 765
- US-A- 5 815 014

## Description

### FIELD OF THE INVENTION

The present invention relates to a frequency multiplying arrangement having the features of the first part of claim 1. The invention also relates to a corresponding method for multiplying, e.g. doubling, the frequency of a signal.

### STATE OF THE ART

Circuits for frequency generation are fundamental within communication systems, radio systems or radiometer systems. A frequency synthesizer is a circuit generating a very precise, temperature stable frequency according to an external reference frequency. Most of the time the frequency also must have a constant phase difference with respect to the reference signal. For example a multi-standard frequency synthesizer must be able to synthesize different bands of frequencies for for example different wireless standards within telecommunications. A multiband frequency synthesizer often has to be able to synthesize a wide range of frequencies while still satisfying strict phase noise specifications. Single-band frequency synthesizers are commonly used to synthesize a narrow frequency band whereas multiband frequency synthesizers are needed to synthesize multiple frequency bands. Generally there can be said to be three different types of frequency synthesizers, namely the table look-up synthesizer, the direct synthesizer and the indirect or phase locked synthesizer. Today it is aimed at achieving low cost, fully integrated frequency synthesizers, which however is quite difficult since the different components involved, such as low pass filters etc. normally have to be external due to noise requirements etc. Most synthesizers used in mobile telecommunication systems are of the type Phase Locked Loop synthesizers, in the following denoted PLL synthesizers. The reference frequency, which generally is a low frequency, is multiplied by a variable integer (sometimes a fraction of a) number. This is achieved by dividing the output frequency for that number, and adjusting the output frequency such that the divided frequency will equal the reference frequency. Thus, often the frequency generated by the oscillator has to be multiplied by a number N in order to achieve the desired frequency.

It is known to perform both a frequency generation functionality by means of an oscillator and a frequency multiplication by means of one circuit, for example an oscillator at the same time used as a frequency multiplier. However, the conversion of the reference frequency to the multiplied frequency, e.g. the double frequency, is often inefficient and a lot of amplifying circuitry is generally needed and, as referred to above, it may be difficult to provide an integrated circuit.

It is known to use two balanced transistors to obtain a doubled frequency when extracting an output signal over the emitter. At the emitter node the currents on the double frequency are in phase and can thus be extracted over an external load or impedance. However, generally the amplitude is low and it mostly needs to be amplified.

US-A-4 810 976 shows an oscillator which is balanced and in which a resonant impedance network is connected between the control ports of two matched transistors. A capacitor is connected in parallel across the two inputs of the transistors. The inputs of the transistors are connected to a matched current source respectively. The signals at the transistor outputs are summed together at a common node. The signals of resonant frequency in each arm of the oscillator are equal in magnitude but opposite in phase. This means that the signals cancel at the resonant frequency, whereas signals at the second harmonic frequency add constructively and thus are enhanced. The effect will be a net frequency doubling. For high frequency operation bipolar transistors are utilized. However, also this arrangement suffers from the drawbacks referred to above.

DE 102 32 861 shows a frequency doubling arrangement with transistors operating in phase opposition wherein a multiplied harmonic of an input signal is extracted between first impedance means and the collectors of the transistors, which, however, also suffers from disadvantages as discussed above.

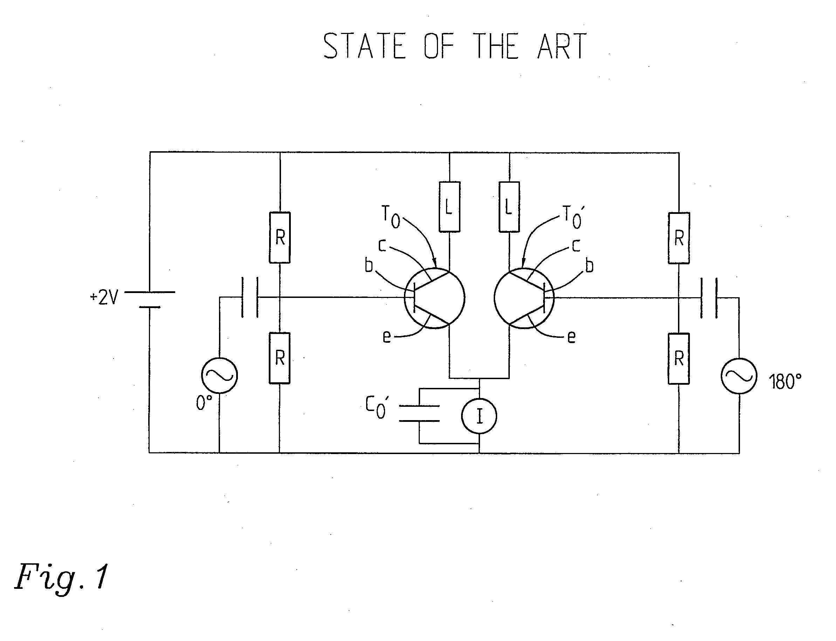

Fig. 1 shows a state of the art balanced amplifier used as a frequency doubler. The two transistors operate in anti-phase and a load is taken out at the emitters of the transistors. The amplitude of the voltage extracted at the double frequency will be quite low for such a circuit due to the fact that the capacitor located after the emitters of the transistors will short-circuit higher frequencies, which is disadvantageous.

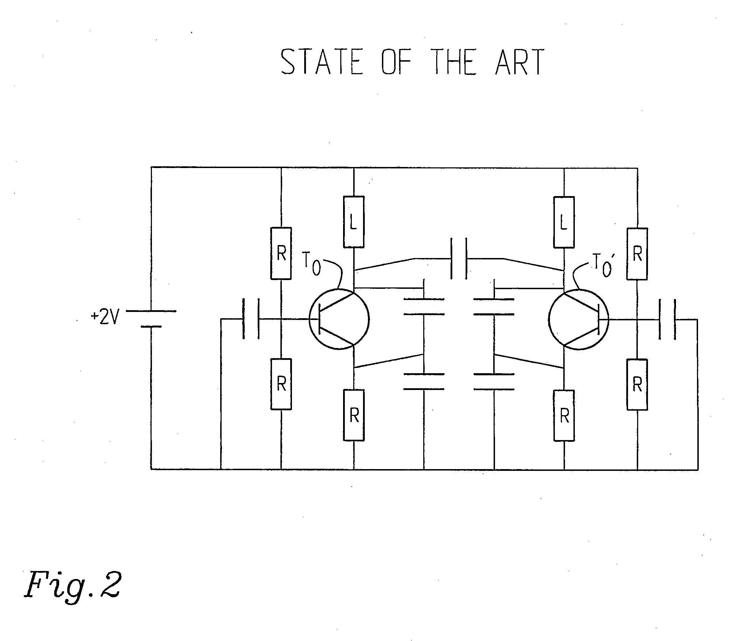

Fig. 2, which is a state of the art figure, shows a so called Colpitt oscillator illustrating two transistors operating in anti-phase. The load is taken out at either of the collectors of the transistors. This will also result in a comparatively low amplitude for the extracted voltage at the double frequency due to the fact that the resonant circuit will short-circuit harmonic overtones.

### SUMMARY OF THE INVENTION

What is needed is therefore a frequency multiplying arrangement as initially referred to for the which the conversion of the reference frequency to a multiple frequency, or particularly to the double frequency, is efficient, particularly such that amplifying circuitry is avoided to an extent which is as high as possible, or even more particularly, completely. Furthermore an arrangement is needed which can be fabricated as a small sized integrated circuit, particularly as a Monolithic Microwave Integrated Circuit (MMIC). Particularly an oscillator is needed through which one or more of the above mentioned objects can be fulfilled. Particularly, an amplifier is needed through which one or more of the above mentioned objects can be achieved. Still further an arrangement is needed through which different kinds of transistors can be used while still allowing fulfillment of providing the objects referred to above.

A method for frequency multiplication is therefore also needed through which one or more of the above mentioned objects can be achieved.

Therefore an arrangement having the characterizing features of claim 1 is provided. A method is also provided having the characterizing features of claim 15. Advantageous or preferred embodiments are given by the appended subclaims.

According to the invention it is thus provided a frequency multiplying arrangement comprising a transistor arrangement with a first and a second transistor, each with an emitter, a base and a collector, a voltage source, output means for extracting an output signal comprising a multiplied output frequency harmonic of an input signal, and impedance means. The impedance means comprises a first impedance means connected to the collectors of the respective transistors, the transistors operating in phase opposition. The waveform of the current for each transistor is half wave shaped such that the transistor is conducting only the half of each period, and the output signal is extracted between the first impedance means and the collectors of the transistors, which collectors are interconnected. The second impedance means comprises a first inductor and a second inductor respectively each connected to a collector of the respective transistors, the output signal being extracted between, at the junction node between the first impedance means and the second impedance means.

In one embodiment the first impedance means comprises an inductor. In another embodiment the first impedance means comprises a resistor. Particularly the collectors of the two transistors are interconnected.

Advantageously the waveform of the current through the transistors is clipped sinusoidal, e.g. half sine/cosine shaped. The sine/cosine shaped includes square sine/cosine shapes. Particularly the output signal is extracted as a voltage drop over said first impedance. In advantageous implementation the first harmonic collector currents of the first and second transistors are 180° out of phase with respect to one another, and for even harmonics, the signals from the respective first and second transistors are in phase. The transistors may be bipolar transistors. Alternatively the transistors are FETs. The impedance means may further comprise second impedance means, said first impedance being connected in series with said second impedance means.

Further yet the second impedance means may comprise a collector circuit comprising a transformer comprising said two inductors, the output signal being extracted between said inductors, i.e. at the mid-output of the transformer.

Said mid-output particularly acts as a virtual short-circuit for odd frequencies, and an output is e.g. extracted at the mid-point as a voltage drop over the first impedance means, e.g. an inductor or a resistor.

The arrangement may comprise a balanced frequency multiplying amplifier, e.g. a frequency doubling amplifier. The arrangement may also comprise an oscillator. Particularly the oscillator comprises a Colpitt oscillator. The arrangement is in preferable embodiments implemented as a MMIC (Monolithic Microwave Integrated Circuit).

### BRIEF DESCRIPTION OF THE DRAWINGS

The invention will in the following be more thoroughly described, in a non-limiting manner, and with reference to the accompanying drawings, in which:
- Fig. 1: shows a state of the art balanced amplifier used as a frequency doubler,
- Fig. 2: shows a state of the art Colpitt oscillator used as a frequency doubler,
- Fig. 3: shows, in a simplified manner, a circuit for providing a multiplied (doubled) frequency according to one implementation of the invention,
- Fig 4: shows, in a simplified manner, a circuit for providing a multiplied (doubled) frequency according to another implementation of the invention,
- Fig. 5: shows a circuit for providing a multiplied (double) frequency which however does not fall within the scope of protection of the present invention,
- Fig. 6: shows a balanced amplifier, according to one implementation of the invention, which is used as a frequency multiplier,
- Fig. 7: shows an oscillator (a Colpitt oscillator) used for frequency multiplication according to another embodiment of the present invention,
- Fig. 8: shows somewhat more in detail an example on a circuit according to the present invention, similar e.g. to the circuit of Fig. 3,
- Fig. 9A: shows the waveform for the voltage of the collector of a first transistor as in Fig. 8,
- Fig. 9B: shows the waveform for the voltage of the collector of a second transistor as in Fig. 8,
- Fig. 9C: shows the waveform of the collector current for a first transistor as in Fig. 8,
- Fig. 9D: shows the waveform of the collector current for a second transistor as in Fig. 8,
- Fig. 10A: shows the waveform of the emitter voltage of a transistor as in arrangement of Fig. 8,
- Fig. 10B: shows the waveform of the base voltage of a transistor as in Fig. 8, and
- Fig. 10C: shows the waveform of the extracted output voltage of an arrangement as in Fig. 8.

### DETAILED DESCRIPTION OF THE INVENTION

Fig. 1 shows a known balanced amplifier, here used as a frequency doubler. The two transistors T₀, T₀' operate in antiphase, i.e. signals applied to the bases of the transistors are maintained in antiphase. The output signal is taken out at the emitters. With this circuit the extracted output voltage gets a low amplitude at the doubled frequency (2xf₀) among others due to the capacitor C₀' after the emitters of the respective transistors acting as a short-circuit for higher frequencies, which is a clear disadvantage.

Fig. 2 shows a known Colpitt oscillator. The two transistors (also here denoted T₀, T₀') in such an oscillator operate in antiphase. The output signal is extracted at the collector of one of the transistors. The amplitude of the output (extracted) voltage will be relatively low at twice the input (reference) frequency (2xf₀), since the resonance circuit will act as a short-circuit for harmonics/overtones.

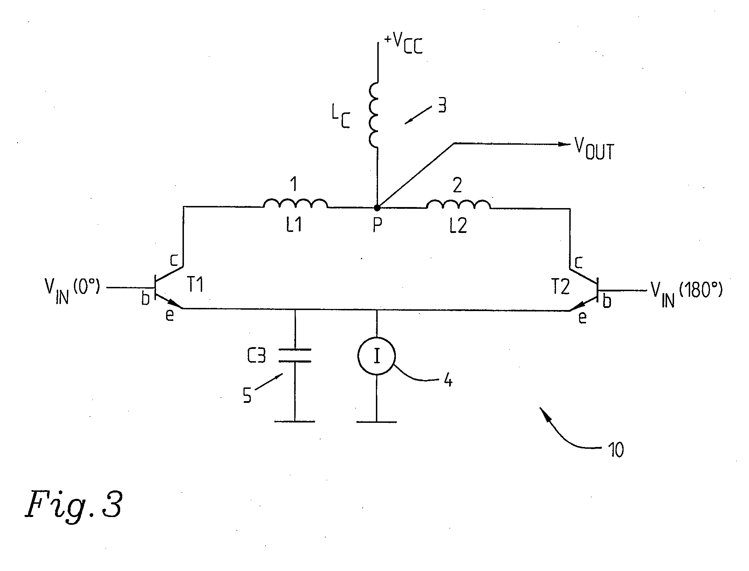

Fig. 3 is a simplified circuit diagram illustrating one implementation of the inventive concept. The circuit of Fig. 3 shows an arrangement 10 comprising a first transistor T1 and a second transistor T2. An input voltage V1ᵢₙ (0°) is provided to T1 and an input voltage V2ᵢₙ (180°) is provided to T2, wherein V1ᵢₙ and V2ᵢₙ are similar but differ 180° in phase in relation to one another. T1 and T2 each comprises a base b, an emitter e and a collector c. It is here supposed that second impedance means are provided comprising two connected inductors L1 1, L2 2, here a transformer with a mid-extraction point P. The mid-extraction point P will here act as a short circuit for odd frequencies since there is an excitation of an odd mode between the collectors c (T1) and c (T2), i.e. they are 180° out of phase. For even overtones even modes are obtained, i.e. the signals are in phase, and even overtones are added. The fundamental frequency component will be substantially cancelled. At the mid-point there will be currents at even frequencies, even harmonics are enhanced, as referred to above, which here are extracted as a voltage drop Vₒᵤₜ (nf) (wherein n e.g. = 2, i.e. at the doubled frequency) over first impedance means 3, here comprising an inductor L_{c} 3. The amplitude of the output voltage Vₒᵤₜ is much higher than a voltage extracted across the emitter (as it is done in prior art).

The current generator 4 is used to set the operation current of the transistors T1, T2 and the capacitor C3 5 is used to ground the emitters (for providing e.g. half cosine shaped pulses). Since the currents are out of phase, there will be no current at the fundamental frequency.

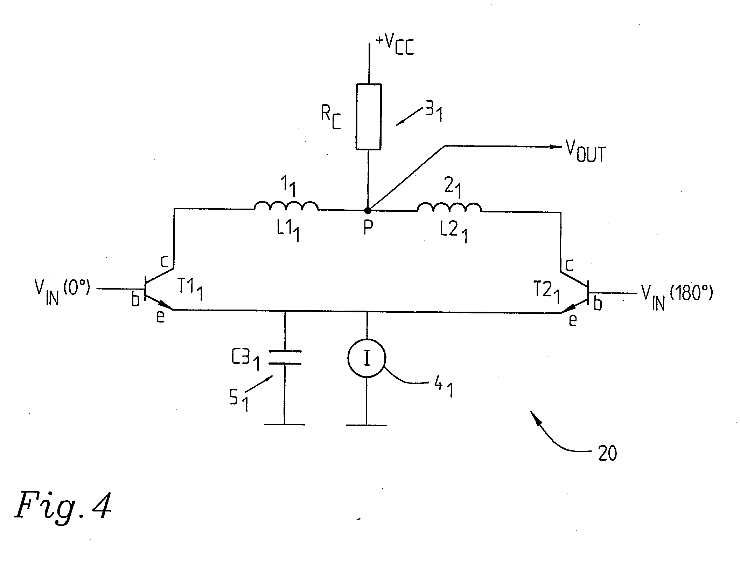

Fig. 4 shows another implementation of the inventive concept in the form of an amplifying and multiplying arrangement 20. The circuit diagram is similar to that of Fig. 3, with the difference that a resistor R_{c} 3₁ is used as first impedance means. In other aspects the functioning is similar, and similar reference numerals provided with an index 1 are used for corresponding components.

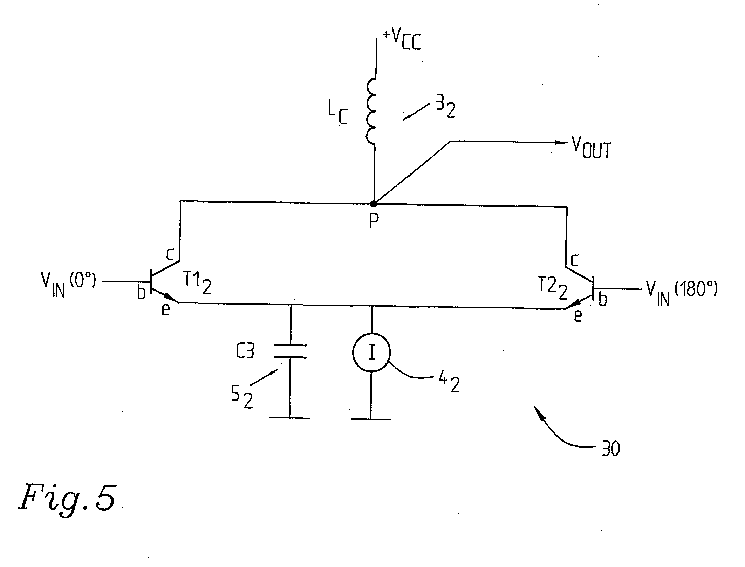

Fig. 5 shows an amplifying and multiplying arrangement 30 with two transistors T1₂, T2₂ wherein Vᵢₙ to T1₂ and T2₂ respectively is 180° out of phase, which does not fall within the scope of the present invention since the collectors of T1₂ and T2₂ respectively are connected directly to each other and there are no second impedance means, but the output voltage Vₒᵤₜ is extracted at the junction where the two collectors are connected, over the first impedance means, here an inductor L_{c} 3₂. Components similar to those of Figs. 3, 4 are given the same reference numerals with index 2.

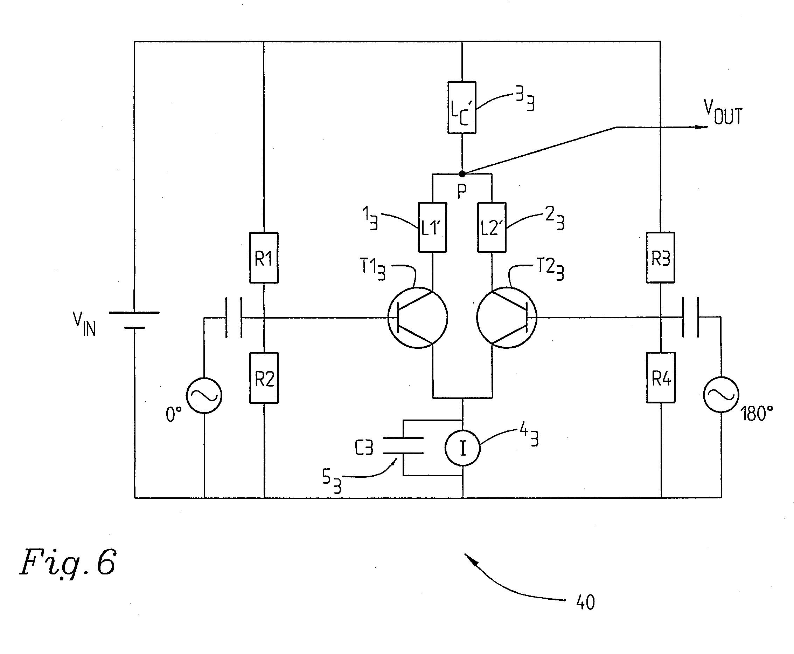

Fig. 6 shows somewhat more in detail an embodiment of an amplifier 40 substantially similar to that disclosed in Fig. 3. Similar components are given similar reference numerals with index 3. A voltage source is used to provide the input voltage Vᵢₙ, and tone generators (0°, 180°) are used to provide input voltages differing 180° in phase to two transistors T1₃, T2₃. Resistors R1-R4 are used to bias the transistors T1₃, T2₃ in a conventional manner. A capacitor C3 5₃ is used to connect the emitters of the transistors to ground such that a half cosine pulse shaped waveform with a lot of (enhanced) harmonics, particularly even harmonics can be provided). The first impedance means L_{c}' 3₃ comprises an inductor connected in series with second impedance means L1' 1₃, L2' 2₃ connected to the collectors of the respective transistors T1₃, T2₃. The output signal Vₒᵤₜ (e.g. V (2f_{ref})) is extracted over the first impedance means L₀' 3₃, i.e. before the second impedance means L1' 1₃, L2' 2₃, e.g. at the junction node P between the first 3₃ and second 1₃, 2₃ impedance means. In other aspects the functioning is similar to that described above.

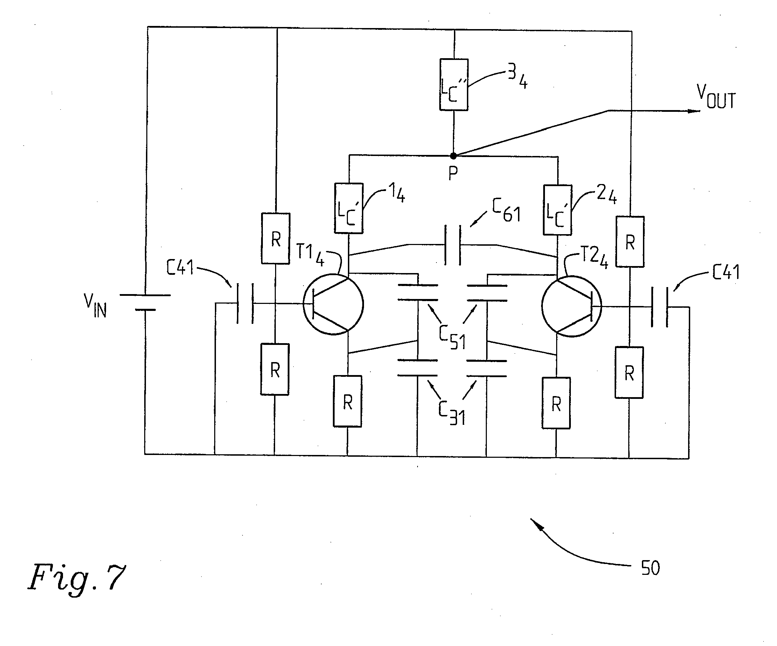

Fig. 7 shows still another implementation of the present invention comprising an oscillator with a frequency multiplying functionality 50 two transistors T1₄, T2₄ operating in anti-phase. The oscillator comprises a so called Colpitt oscillator. Capacitors C₃₁, C₃₁ are used to ground the emitters of the transistors T1₄, T2₄ whereas capacitors C₄₁, C₄₁ are used to ground the bases of the transistors T1₄, T2₄. Capacitor C₆₁ forms part of a resonant circuit comprising second impedance means L₂₁ 1₄, L₃₁ 2₄ such that the inductors 1₄, 2₄ and the capacitor C₆₁ form a parallel resonant circuit for the oscillator. The output voltage Vₒᵤₜ is extracted at the node between the first impedance means consisting of inductor L_{c}" 3₄ and the second impedance means comprising the resonant circuit. The resistors all denoted R function in a manner similar to that of prior art arrangements and will therefore not be further described herein. Capacitors C₅₁, C₅₁ are feedback capacitors.

Like in the arrangements comprising amplifiers, the transistors operate in anti-phase. In an arrangement as discussed above, there will be a higher current through collector-emitter and since the transistors operate in anti-phase, half-wave wave forms are provided and even harmonics are enhanced whereas the fundamental frequency is cancelled. Since Vₒᵤₜ is extracted over the first impedance means 3₄, at the junction between the first and second impedance means, the voltage that can be extracted will be very much higher than in known arrangements where the output voltage is extracted over the emitters.

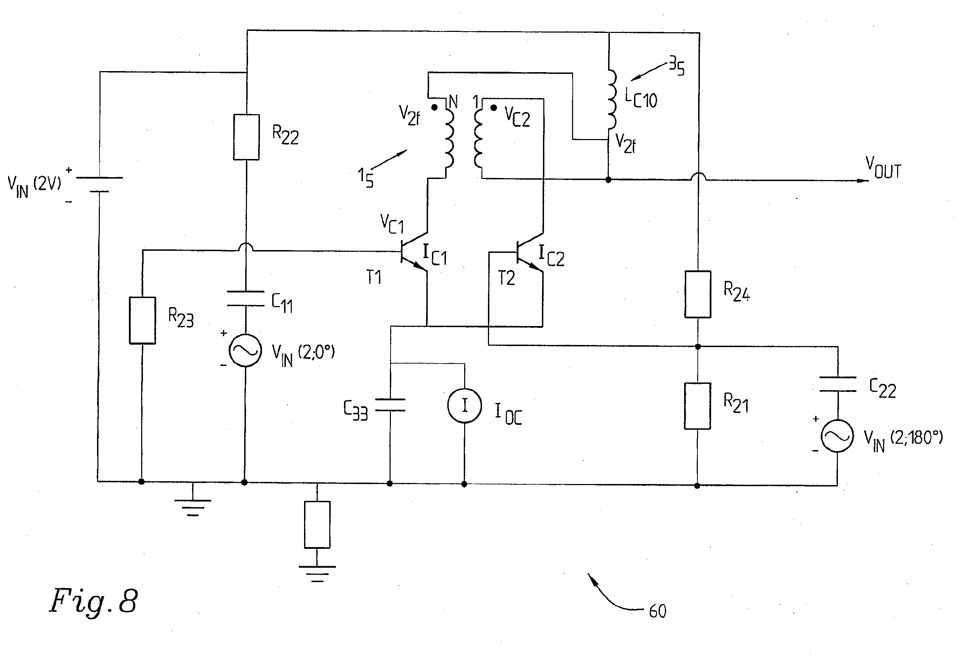

Fig. 8 is a somewhat more detailed illustration of an arrangement according to the invention which shows a frequency multiplying amplifier 60.

An input voltage Vᵢₙ (DC) of 2[V] is here used. Of course other voltages can be used. For exemplifying, by no means limiting, reasons, numerical values are given for the different components etc. As in the embodiments described in the foregoing, the arrangement 60 comprises a first and a second transistor T1, T2 respectively. A DC supply voltage of 2 Volts is, as referred to above, used and Vᵢₙ (2V, 0°) is supplied to T1, whereas Vᵢₙ (2V, 180°) is supplied to T2, i.e. the input supply voltages are 180° out of phase with respect to one another. Resistors R₂₁, R₂₂, R₂₃, R₂₄ are used for biasing the transistors T1, T2. Also capacitors C₁₁, C₂₁ are used for biasing the transistors. R₂₂ may have a resistance of e.g. 5kΩ, R₂₃ of 5,2kΩ, R₂₁ of 5,2kΩ and R₂₄ of 5kΩ, whereas C₁₁, C₂₂ each may have a capacitance of 1, 0µF. C₃₃ may have a capacitance of 2pF and it is used to ground the emitters of T1 and T2 such that the waveform will be half-wave shaped, e.g. comprise a half cosine pulse. As referred to earlier in the application, the output signal will have much overtones (the fundamental component being suppressed), particularly even harmonics, which are added, which is exceedingly advantageous. I_{DC} may comprise 8 [mA].

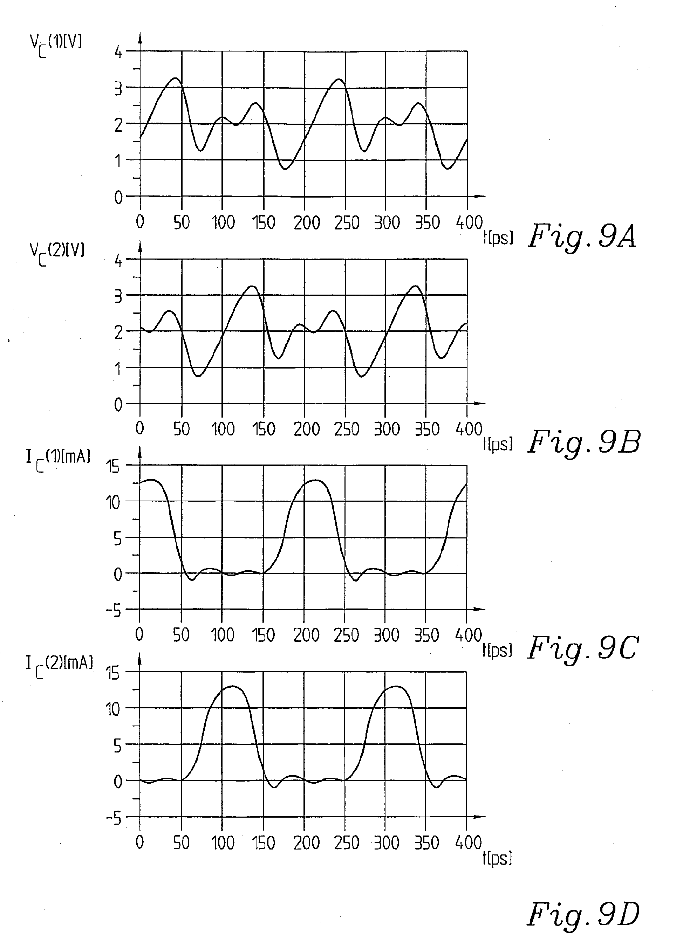

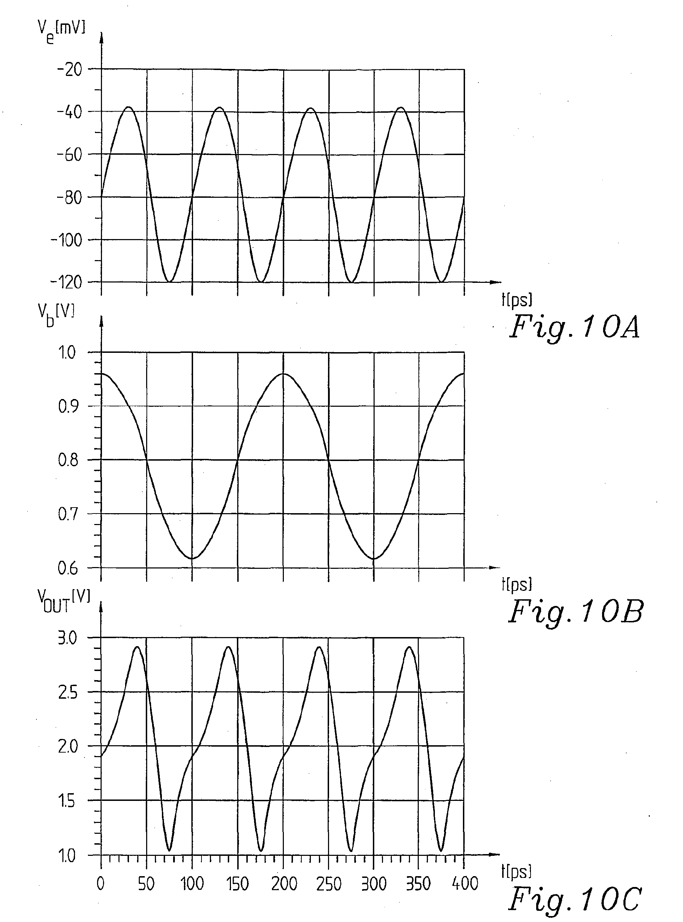

V_{base} indicates the voltage over the transistor bases (cf. Fig. 10B). V_{c1}, V_{c2} indicate the collector voltages, cf. Figs. 9A, 9B and Vₑ is the emitter voltage (cf. Fig. 10A). I_{c1} and I_{c2} indicate the collector currents of T1 and T2 respectively, cf. Figs. 9C, 9D. Figs. 9A-9D, 10A-10C below illustrate the waveforms of the signals in an arrangement similar to that described above with reference to Fig. 8. Particularly Fig. 10C illustrates Vₒᵤₜ, i.e. the extracted output voltage (at, here, doubled frequency).

1₂₁ indicates (Fig. 8) the second impedance means, here comprising a transformer connected to the collectors of T1 and T2. In series with said transformer 1₂₁ first impedance means inductor L_{c10} are connected over which Vₒᵤₜ is extracted (cf. also Fig. 10C). L_{c10} here e.g. has an inductance of 20 nH.

In Figs. 9A-9D, 10A-10C signal waveforms are illustrated in diagrams for an embodiment in which Vᵢₙ = 200 mV, Ie = 4 mA, Ce = 2 pF and the transformer inductance L = 2 nH.

Figs. 9A, 9B show the waveforms for the collector voltages V_{c1}, V_{c2} for T1 and T2 respectively in [V] as a function of time (in ps). Figs. 9C, 9D illustrate the collector currents I_{c1}, I_{c2} in [mA] as a function of time (in [ps]) for T1 and T2 respectively. As can be seen the signals, comprise half cosine pulses; half of the cycle is zero and therebetween (or the remainder of the signals) is sine/cosine shaped. Thus, there are a lot of overtones (even), which are added, and these currents are attractive for extraction.

Fig. 10A shows the variation in emitter voltage in [mV] as a function of time (in ps). As can be seen from the figure, the emitter peak-to-peak voltage is 80 mV.

Fig. 10B shows the transistor base voltage [V] as a function of time in [ps]. Finally Fig. 10C shows the extracted output voltage Vₒᵤₜ in [V] as a function of time in [ps], i.e. the voltage of the multiplied (here doubled) frequency signal. As referred to earlier in the application it is particularly the output voltage (Vₒᵤₜ) in the node junction between the first and the second impedance means. The amplitude of the signal Vₚ₋ₚ (V peak-to-peak) = 1,9 [V] as can be seen from Fig. 10C. The conversion gain G_{c} will then be 1,9 [V] / 0,4 [V] ≈ 5; 0,4 being 2 x 0,2, wherein 0,2 is the amplitude of the input signal, i.e. the sum of the amplitudes of the two input signals will be 0,4. For a corresponding, conventional arrangement the conversion gain would be approximately 0,15 / 0,4 ≈ 0,4 i.e. Vₒᵤₜ = 0,15 [V], and G_{c} of an arrangement according to the present invention would (in this particular embodiment) thus be more than 10 times the conversion gain G_{c} of an arrangement in which the output voltage is extracted over the emitter.

Although it is mainly referred to a frequency doubled signal, it should be clear that also other (even) overtones (harmonics) are provided, and summed, whereas the fundamental component is cancelled, as well as odd overtones.

Particularly the arrangement is implemented as a Monolithic Microwave Integrated Circuit (MMIC).

Different kinds of transistors can be used, e.g. bipolar transistor, FETs etc. According to the invention a signal of 2 x the reference frequency (or an even factor x the reference frequency) can be extracted at virtual ground of the resonant circuit in the case of an oscillator (or an amplifier).

It should be clear that the invention of course not is limited to the explicitly illustrated embodiments, but that it can be varied in a number of ways within the scope of the appended claims.

## Claims

1. A frequency multiplying arrangement (10;20;30;40;50;60) comprising a transistor arrangement with a first and a second transistor (T1, T2; T1₁, T2₁; T1₂, T2₂; T1₃, T2₃; T1₄, T2₄), the transistors operating in phase opposition, each with an emitter (e), a base (b) and a collector (c), a voltage or current source, the waveform of the current for each transistor being half wave shaped such that the transistor is conducting only the half of each period, output means for extracting an output signal (Vₒᵤₜ) comprising a multiplied output frequency harmonic of an input signal (Vᵢₙ) provided to the transistors, the collectors of the two transistors (T1₂, T2₂) being interconnected via impedance means comprising a first impedance means (3; 3₁; 3₂; 3₃; 3₄; 3₅) connected to the collectors of the first and second transistors, the impedance means further comprising second impedance means (1,2; 1₁,2₁; 1₃,2₃; 1₄,2₄; 1₅), said first impedance means (3; 3₁; 3₂; 3₃; 3₄; 3₅) being connected in series with said second impedance means (1,2; 1₁,2₁; 1₃,2₃; 1₄,2₄; 1₅), c h a r a c t e r i z e d i n
that said second impedance means (1,2; 1₁,2₁; 1₃,2₃; 1₄,2₄; 1₅) comprises a first inductor (1; 1₁; 1₃; 1₄; 1₅) and a second inductor (2; 2₁; 2₃; 2₄; 1₅) one end of each inductor being connected to the collector of a respective one of the first and second transistors, wherein the first and second impedance means and the first and second inductors are interconnected at a junction node (P) such that the first impedance means is connected with the collector of the first transistor (T1) over the first inductor (1) of the second impedance means (1,2) and with the collector of the second transistor (T₂) over the second inductor (2) of the second impedance means, wherein the output signal (Vₒᵤₜ), is extracted at said junction node between the first and second impedance means and that a capacitor (5; 5₁; 5₂; 5₃; C₃₁,C₃₁; C₃₃) is connected to the emitters of the transistors and arranged to connect the emitters to ground.

2. An arrangement according to claim 1,
c h a r a c t e r i z e d i n
that the first impedance means comprises an inductor (3; 3₂; 3₃; 3₄; 3₅).

3. An arrangement according to claim 1,
c h a r a c t e r i z e d i n
that the first impedance means comprises a resistor (3₁).

4. An arrangement according to any one of the preceding claims,
**characterized** i n
that the waveform of the current through the transistors is clipped sinusoidal.

5. An arrangement according to any one of the preceding claims,
c h a r a c t e r i z e d i n
that the output signal (Vₒᵤₜ) is extracted as a voltage drop over said first impedance (3; 3₁; 3₂; 3₃; 3₄; 3₅).

6. An arrangement according to any one of the preceding claims,
c h a r a c t e r i z e d i n
that the first harmonic collector currents of the first and second transistors are 180° out of phase with respect to one another.

7. An arrangement according to any one of the preceding claims,
**characterized** i n
that the transistors are bipolar transistors.

8. An arrangement according to any one of the preceding claims,
c h a r a c t e r i z e d i n
that the second impedance means comprises a collector circuit comprising a transformer (1₅) comprising said two inductors and in that the output signal (Vₒᵤₜ) is extracted between said inductors, i.e. at the mid-output (P) of the transformer.

9. An arrangement according to claim 8,
that said mid-output (P) acts as a virtual short-circuit for odd frequencies.

10. An arrangement according to claim 9,
c h a r a c t e r i z e d i n
that an output is extracted at the mid-point (P) as a voltage drop over the first impedance means (3; 3₁; 3₂; 3₃; 3₄; 3₅) comprising an inductor or a resistor.

11. An arrangement according to any one of the preceding claims,
c h a r a c t e r i z e d i n
that it comprises a balanced frequency multiplying amplifier (10; 20; 30; 40; 60).

12. An arrangement according to any one of the preceding claims,
c h a r a c t e r i z e d i n
that it comprises an oscillator (50).

13. An arrangement according to claim 12,
c h a r a c t e r i z e d **in**
that the oscillator (50) comprises a Colpitt oscillator.

14. An arrangement according to any one of the preceding claims,
c h a r a c t e r i z e sd i n
that it is implemented as a MMIC, Monolithic Microwave Integrated Circuit.

15. A method of multiplying a reference frequency of an input signal (Vᵢₙ) by means of an arrangement comprising a transistor arrangement with a first and a second transistor (T1,T2; T1₁,T2₁; T1₂,T2₂; T1₃,T2₃; T1₄,T2₄), each with an emitter (e), a base (b) and a collector (c), and a current or voltage source, the transistors operating in phase opposition, the waveform of the current for each transistor being half wave shaped such that the transistor is conducting only the half of each period, the collectors of the two transistors (T1₂,T2₂) being interconnected via impedance means comprising a first impedance means (3; 3₁; 3₂; 3₃; 3₄; 3₅) connected to the collectors of the first and second transistors, the impedance means further comprising second impedance means (1,2; 1₁,2₁; 1₃,2₃; 1₄,2₄; 1₅), said first impedance means (3; 3₁; 3₂; 3₃; 3₄; 3₅) being connected in series with said second impedance means (1,2; 1₁,2₁; 1₃,2₃; 1₄,2₄; 1₅), and, extracting, via output means, an output signal (Vₒᵤₜ) comprising a multiplied output frequency harmonic of the input signal (Vᵢₙ) provided to the transistors,
c h a r a c t e r i z e d i n
that said second impedance means (1,2; 1₁,2₁; 1₃,2₃; 1₄,2₄; 1₅) comprises a first inductor (1; 1₁; 1₃; 1₄; 1₅) and a second inductor (2; 2₁; 2₃; 2₄; 1₅) one end of each inductor being connected to the collector of a respective one of the first and second transistors, wherein the first and second impedance means and the first and second inductors are interconnected at a junction node (P) such that the first impedance means is connected with the collector of the first transistor (T1) over the first inductor (1) of the second impedance means (1,2) and with the collector of the second transistor (T₂) over the second inductor (2) of the second impedance means, that a capacitor (5; 5₁; 5₂; 5₃; C₃₁,C₃₁; C₃₃) is connected to the emitters of the transistors and arranged to connect the emitters to ground, and in that the method comprises the steps of:
- providing the input signal (Vᵢₙ) to the first transistor and to the second transistor the collector currents of which being 180° out of phase so that signals differing 180° in phase are provided,
- adding the out of phase signals,
- extracting the output signal (Vₒᵤₜ) at said junction node between the first and second impedance means.

16. A method according to claim 15,
c h a r a c t e r i z e d i n
that the first impedance means comprises an inductor.

17. A method according to claim 15,
c h a r a c t e r i z e d i n
that the first impedance means comprises a resistor.

## Patentansprüche

1. Frequenzvervielfachungsanordnung (10; 20; 30; 40; 50; 60), umfassend eine Transistoranordnung mit einem ersten und einem zweiten Transistor (T1, T2; T1₁, T2₁; T1₂, T2₂; T1₃, T2₃; T1₄, T2₄), wobei die Transistoren in Gegenphasigkeit arbeiten, jeweils mit einem Emitter (e), einer Basis (b) und einem Kollektor (c), eine Spannungs- oder Stromquelle, wobei die Wellenform des Stroms für jeden Transistor halbwellenförmig ist, derart dass der Transistor nur die Hälfte jeder Periode leitend ist, Ausgabemittel zum Extrahieren eines Ausgangssignals (Vₒᵤₜ), das eine Oberschwingung einer vervielfachten Ausgangsfrequenz eines Eingangssignals (Vᵢₙ) umfasst, das an die Transistoren geliefert wird, wobei die Kollektoren der beiden Transistoren (T1₂, T2₂) über Impedanzmittel miteinander verbunden sind, die ein erstes Impedanzmittel (3; 3₁; 3₂; 3₃; 3₄; 3₅) umfassen, das mit den Kollektoren der ersten und zweiten Transistoren verbunden ist, wobei die Impedanzmittel ferner ein zweites Impedanzmittel (1, 2; 1₁, 2₁; 1₃, 2₃; 1₄, 2₄; 1₅) umfassen, wobei das erste Impedanzmittel (3; 3₁; 3₂; 3₃; 3₄; 3₅) mit dem zweiten Impedanzmittel (1, 2; 1₁, 2₁; 1₃, 2₃; 1₄, 2₄; 1₅) in Reihe geschaltet ist,
**dadurch gekennzeichnet, dass**
das zweite Impedanzmittel (1, 2; 1₁, 2₁; 1₃, 2₃; 1₄, 2₄; 1₅) einen ersten Induktor (1; 1₁; 1₃; 1₄; 1₅) und einen zweiten Induktor (2; 2₁; 2₃; 2₄; 1₅) umfasst, wobei ein Ende jedes Induktors mit dem Kollektor eines jeweiligen der ersten und zweiten Transistoren verbunden ist, wobei die ersten und zweiten Impedanzmittel und die ersten und zweiten Induktoren an einem Übergangsknoten (P) miteinander verbunden sind, derart dass das erste Impedanzmittel über den ersten Induktor (1) des zweiten Impedanzmittels (1, 2) mit dem Kollektor des ersten Transistors (T₁) und über den zweiten Induktor (2) des zweiten Impedanzmittels mit dem Kollektor des zweiten Transistors (T₂) verbunden ist, wobei das Ausgangssignal (Vₒᵤₜ) am Übergangsknoten zwischen den ersten und zweiten Impedanzmitteln extrahiert wird, und dass ein Kondensator (5; 5₁; 5₂; C₃₁, C₃₁; C₃₃) mit den Emittern der Transistoren verbunden und derart angeordnet ist, dass er die Emitter mit Erde verbindet.

2. Anordnung nach Anspruch 1,
**dadurch gekennzeichnet, dass**
das erste Impedanzmittel einen Induktor (3; 3₂; 3₃; 3₄; 3₅) umfasst.

3. Anordnung nach Anspruch 1,
**dadurch gekennzeichnet, dass**
das erste Impedanzmittel einen Widerstand (3₁) umfasst.

4. Anordnung nach einem der vorhergehenden Ansprüche,
**dadurch gekennzeichnet, dass**
die Wellenform des Stroms durch die Transistoren sinusförmig beschnitten wird.

5. Anordnung nach einem der vorhergehenden Ansprüche,
**dadurch gekennzeichnet, dass**
das Ausgangssignal (Vₒᵤₜ) als ein Spannungsabfall über die erste Impedanz (3; 3₁; 3₂; 3₃; 3₄; 3₅) extrahiert wird.

6. Anordnung nach einem der vorhergehenden Ansprüche,
**dadurch gekennzeichnet, dass**
die Kollektor-Grundschwingungsströme der ersten und zweiten Transistoren in Bezug aufeinander um 180° phasenverschoben sind.

7. Anordnung nach einem der vorhergehenden Ansprüche,
**dadurch gekennzeichnet, dass**
die Transistoren Bipolartransistoren sind.

8. Anordnung nach einem der vorhergehenden Ansprüche,
**dadurch gekennzeichnet, dass**
das zweite Impedanzmittel eine Kollektorschaltung umfasst, die einen Transformator (1₅) umfasst, der die beiden Induktoren umfasst, und dadurch, dass das Ausgangssignal (Vₒᵤₜ) zwischen den Induktoren, d. h. am mittleren Ausgang (P) des Transformator, extrahiert wird.

9. Anordnung nach Anspruch 8,
dass der mittlere Ausgang (P) als virtueller Kurzschluss für ungeradzahlige Frequenzen fungiert.

10. Anordnung nach Anspruch 9,
**dadurch gekennzeichnet, dass**
eine Ausgabe am Mittelpunkt (P) als ein Spannungsabfall über das erste Impedanzmittel (3; 3₁; 3₂; 3₃; 3₄; 3₅), das einen Induktor oder einen Widerstand umfasst, extrahiert wird.

11. Anordnung nach einem der vorhergehenden Ansprüche,
**dadurch gekennzeichnet, dass**
sie einen symmetrischen Frequenzvervielfachungsverstärker (10; 20; 30; 40; 60) umfasst.

12. Anordnung nach einem der vorhergehenden Ansprüche,
**dadurch gekennzeichnet, dass**
sie einen Oszillator (50) umfasst.

13. Anordnung nach Anspruch 12,
**dadurch gekennzeichnet, dass**
der Oszillator (50) einen Colpitts-Oszillator umfasst.

14. Anordnung nach einem der vorhergehenden Ansprüche,
**dadurch gekennzeichnet, dass**
sie als eine monolithische integrierte Mikrowellenschaltung, MMIC, implementiert ist.

15. Verfahren zur Vervielfachung einer Bezugsfrequenz eines Eingangssignals (Vᵢₙ) mithilfe einer Anordnung, die eine Transistoranordnung mit einem ersten und einem zweiten Transistor (T1, T2; T1₁, T2₁; T1₂, T2₂; T1₃, T2₃; T1₄, T2₄), jeweils mit einem Emitter (e), einer Basis (b) und einem Kollektor (c), und eine Strom- oder Spannungsquelle umfasst, wobei die Transistoren in Gegenphasigkeit arbeiten, die Wellenform des Stroms für jeden Transistor halbwellenförmig ist, so dass der Transistor nur die Hälfte jeder Periode leitend ist, die Kollektoren der beiden Transistoren (T1₂, T2₂) über Impedanzmittel miteinander verbunden sind, die ein erstes Impedanzmittel (3; 3₁; 3₂; 3₃; 3₄; 3₅) umfassen, das mit den Kollektoren der ersten und zweiten Transistoren verbunden ist, die Impedanzmittel ferner ein zweites Impedanzmittel (1, 2; 1₁, 2₁; 1₃, 2₃; 1₄, 2₄; 1₅) umfassen, das erste Impedanzmittel (3; 3₁; 3₂; 3₃; 3₄; 3₅) mit dem zweiten Impedanzmittel (1, 2; 1₁, 2₁; 1₃, 2₃; 1₄, 2₄; 1₅) in Reihe geschaltet ist, und Extrahieren über Ausgabemittel eines Ausgangssignals (Vₒᵤₜ), das eine Oberschwingung einer vervielfachten Ausgangsfrequenz des Eingangssignals (Vᵢₙ) umfasst, das an die Transistoren geliefert wird,
**dadurch gekennzeichnet, dass**
das zweite Impedanzmittel (1, 2; 1₁, 2₁; 1₃, 2₃; 1₄, 2₄; 1₅) einen ersten Induktor (1; 1₁; 1₃; 1₄; 1₅) und einen zweiten Induktor (2; 2₁; 2₃; 2₄; 1₅) umfasst, wobei ein Ende jedes Induktors mit dem Kollektor eines jeweiligen der ersten und zweiten Transistoren verbunden ist, wobei die ersten und zweiten Impedanzmittel und die ersten und zweiten Induktoren an einem Übergangsknoten (P) miteinander verbunden sind, derart dass das erste Impedanzmittel über den ersten Induktor (1) des zweiten Impedanzmittels (1, 2) mit dem Kollektor des ersten Transistors (T₁) und über den zweiten Induktor (2) des zweiten Impedanzmittels mit dem Kollektor des zweiten Transistors (T₂) verbunden ist, dass ein Kondensator (5; 5₁; 5₂; C₃₁, C₃₁; C₃₃) mit den Emittern der Transistoren verbunden und derart angeordnet ist, dass er die Emitter mit Erde verbindet, und dadurch, dass Verfahren die folgenden Schritte umfasst:
- Liefern des Eingangssignals (Vᵢₙ) an den ersten Transistor und an den zweiten Transistor, deren Kollektorströme um 180° phasenverschoben sind, so dass Signale mit einem Phasenunterschied von 180° bereitgestellt werden,
- Addieren der phasenverschobenen Signale,
- Extrahieren des Ausgangssignals (Vₒᵤₜ) am Übergangsknoten zwischen den ersten und zweiten Impedanzmitteln.

16. Verfahren Anspruch 15,
**dadurch gekennzeichnet, dass**
das erste Impedanzmittel einen Induktor umfasst.

17. Verfahren Anspruch 15,
**dadurch gekennzeichnet, dass**
das erste Impedanzmittel einen Widerstand umfasst.

## Revendications

1. Aménagement multiplicateur de fréquence (10 ; 20 ; 30 ; 40 ; 50 ; 60) comprenant un aménagement transistorisé avec un premier et un second transistor (T1,T2 ; T1₁,T2₁ ; T1₂,T2₂ ; T1₃, T2₃ ; T1₄,T2₄), les transistors fonctionnant en opposition de phase, chacun avec un émetteur (e), une base (b) et un collecteur (c), une source de tension ou de courant, la forme d'onde du courant de chaque transistor étant conformée en demi-onde de sorte que le transistor ne conduise que la moitié de chaque période, des moyens de sortie pour extraire un signal de sortie (Vₛₒᵣₜᵢₑ) comprenant une harmonique de fréquence de sortie multipliée d'un signal d'entrée (V_{entrée}) délivré aux transistors, les collecteurs des deux transistors (T1₂, T2₂) étant interconnectés via des moyens à impédance comprenant un premier moyen à impédance (3 ; 3₁ ; 3₂ ; 3₃ ; 3₄ ; 3₅) connecté aux collecteurs des premier et second transistors, les moyens à impédance comprenant en outre un second moyen à impédance (1,2 ; 1₁,2₁ ; 1₃,2₃ ; 1₄,2₄ ; 1₅), ledit premier moyen à impédance (3 ; 3₁ ; 3₂ ; 3₃ ; 3₄ ; 3₅) étant connecté en série audit second moyen à impédance (1,2 ; 1₁,2₁ ; 1₃,2₃ ; 1₄,2₄ ; 1₅),
**caractérisé en ce que**
ledit second moyen à impédance (1,2 ; 1₁,2₁ ; 1₃,2₃ ; 1₄,2₄ ; 1₅) comprend un premier inducteur (1 ; 1₁ ; 1₃ ; 1₄ ; 1₅) et un second inducteur (2 ; 2₁ ; 2₃ ; 2₄ ; 1₅), une extrémité de chaque inducteur étant connectée au collecteur du transistor respectif d'entre le premier et le second transistor, dans lequel les premier et second moyens à impédance et les premier et second inducteurs sont interconnectés à un noeud de jonction (P) de sorte que le premier moyen à impédance soit connecté au collecteur du premier transistor (T₁) via le premier inducteur (1) du second moyen à impédance (1,2) et au collecteur du second transistor (T₂) via le second inducteur (2) du second moyen à impédance, dans lequel le signal de sortie (Vₛₒᵣₜᵢₑ) est extrait audit noeud de jonction entre les premier et second moyens à impédance, et un condensateur (5 ; 5₁ ; 5₂ ; 5₃ ; C₃₁,C₃₁ ; C₃₃) est connecté aux émetteurs des transistors et aménagé pour connecter les émetteurs à la terre.

2. Aménagement selon la revendication 1,
**caractérisé en ce que**
le premier moyen à impédance comprend un inducteur (3 ; 3₂ ; 3₃ ; 3₄ ; 3₅).

3. Aménagement selon la revendication 1,
**caractérisé en ce que**
le premier moyen à impédance comprend une résistance (3₁).

4. Aménagement selon l'une quelconque des revendications précédentes,
**caractérisé en ce que**
la forme d'onde du courant passant par les transistors est écrêtée à la forme sinusoïdale.

5. Aménagement selon l'une quelconque des
revendications précédentes,
**caractérisé en ce que**
le signal de sortie (Vₛₒᵣₜᵢₑ) est extrait sous le forme d'une chute de tension sur ladite première impédance (3 ; 3₂ ; 3₃ ; 3₄ ; 3₅).

6. Aménagement selon l'une quelconque des
revendications précédentes,
**caractérisé en ce que**
les courants collecteurs de première harmonique des premiers et second transistors sont déphasés de 180 ° l'un de l'autre.

7. Aménagement selon l'une quelconque des
revendications précédentes,
**caractérisé en ce que**
les transistors sont des transistors bipolaires.

8. Aménagement selon l'une quelconque des revendications précédentes,
**caractérisé en ce que**
le second moyen à impédance comprend un circuit collecteur comprenant un transformateur (1₅) comprenant lesdits deux inducteurs et le signal de sortie (Vₛₒᵣₜᵢₑ) est extrait entre lesdits inducteurs, c'est-à-dire à mi-sortie (P) du transformateur.

9. Aménagement selon la revendication 8,
ladite mi-sortie (P) agit comme un court-circuit virtuel pour les fréquences impaires.

10. Aménagement selon la revendication 9,
**caractérisé en ce que**
une sortie est extraite au point central (P) comme une chute de tension sur le premier moyen à impédance (3 ; 3₂ ; 3₃ ; 3₄ ; 3₅) comprenant un inducteur ou une résistance.

11. Aménagement selon l'une quelconque des revendications précédentes,
**caractérisé en ce que**
il comprend un amplificateur multiplicateur de fréquence équilibré (10 ; 20 ; 30 ; 40 ; 60).

12. Aménagement selon l'une quelconque des revendications précédentes,
**caractérisé en ce que**
il comprend un oscillateur (50).

13. Aménagement selon la revendication 12,
**caractérisé en ce que**
l'oscillateur (50) comprend un oscillateur de Colpitt.

14. Aménagement selon l'une quelconque des revendications précédentes,
**caractérisé en ce que**
il est mis en oeuvre sous la forme d'un MMIC, c'est-à-dire d'un circuit intégré à micro-ondes monolithique.

15. Procédé visant à multiplier une fréquence de référence d'un signal d'entrée (V_{entrée}) au moyen d'un aménagement comprenant un aménagement transistorisé avec un premier et un second transistor (T1,T2 ; T1₁,T2₁ ; T1₂,T2₂ ; T1₃,T2₃ ; T1₄,T₂4), chacun avec un émetteur (e), une base (b) et un collecteur (c), et une source de courant ou de tension, les transistors fonctionnant en opposition de phase, la forme d'onde du courant de chaque transistor étant conformée en demi-onde de sorte que le transistor ne conduise que la moitié de chaque période, les collecteurs des deux transistors (T1₂, T2₂) étant interconnectés via des moyens à impédance comprenant un premier moyen à impédance (3 ; 3₁ ; 3₂ ; 3₃ ; 3₄ ; 3₅) connecté aux collecteurs des premier et second transistors, les moyens à impédance comprenant en outre un second moyen à impédance (1, 2 ; 1₁,2₁ ; 1₃,2₃ ; 1₄,2₄ ; 1₅), ledit premier moyen à impédance (3 ; 3₁ ; 3₂ ; 3₃ ; 3₄ ; 3₅) étant connecté en série audit second moyen à impédance (1,2 ; 1₁,2₁ ; 1₃,2₃ ; 1₄,2₄ ; 1₅), et à extraire, via des moyens de sortie, un signal de sortie (Vₛₒᵣₜᵢₑ) comprenant une harmonique de fréquence de sortie multipliée du signal d'entrée (V_{entrée}) délivré aux transistors, **caractérisé en ce que**
ledit second moyen à impédance (1,2 ; 1₁,2₁ ; 1₃, 2₃ ; 1₄,2₄ ; 1₅) comprend un premier inducteur (1 ; 1₁ ; 1₃ ; 1₄ ; 1₅) et un second inducteur (2 ; 2₁ ; 2₃ ; 2₄ ; 1₅), une extrémité de chaque inducteur étant connectée au collecteur du transistor respectif d'entre le premier et le second transistor, dans lequel les premier et second moyens à impédance et les premier et second inducteurs sont interconnectés à un noeud de jonction (P) de sorte que le premier moyen à impédance soit connecté au collecteur du premier transistor (T₁) via le premier inducteur (1) du second moyen à impédance (1,2) et au collecteur du second transistor (T₂) via le second inducteur (2) du second moyen à impédance, un condensateur (5 ; 5₁ ; 5₂ ; 5₃ ; C₃₁,C₃₁ ; C₃₃) est connecté aux émetteurs des transistors et aménagé pour connecter les émetteurs à la terre, et le procédé comprend les étapes consistant à :
- délivrer le signal d'entrée (V_{entrée}) au premier transistor et au second transistor, dont les courants collecteurs sont déphasés de 180 ° de sorte que des signaux différant de 180 ° en phase soient fournis,
- ajouter les signaux déphasés, et
- extraire le signal de sortie (Vₛₒᵣₜᵢₑ) audit noeud de jonction entre le premier et le second moyen à impédance.

16. Procédé selon la revendication 15,
**caractérisé en ce que**
le premier moyen à impédance comprend un inducteur.

17. Procédé selon la revendication 15,
**caractérisé en ce que**
le premier moyen à impédance comprend une résistance.
